(19) **Europäisches Patentamt / European Patent Office / Office européen des brevets**

(11) **EP 1 768 464 A1**

(12) **EUROPEAN PATENT APPLICATION**
published in accordance with Art. 158(3) EPC

(43) Date of publication:
**28.03.2007 Bulletin 2007/13**

(21) Application number: **05727177.7**

(22) Date of filing: **23.03.2005**

(51) Int Cl.:
**H05B 33/04** *(2006.01)*    **H05B 33/02** *(2006.01)*
**H05B 33/12** *(2006.01)*    **H05B 33/14** *(2006.01)*

(86) International application number:
**PCT/JP2005/005236**

(87) International publication number:
**WO 2005/099311 (20.10.2005 Gazette 2005/42)**

(84) Designated Contracting States:
**AT BE BG CH CY CZ DE DK EE ES FI FR GB GR HU IE IS IT LI LT LU MC NL PL PT RO SE SI SK TR**

(30) Priority: **05.04.2004 JP 2004110695**
**10.06.2004 JP 2004172348**

(71) Applicant: **IDEMITSU KOSAN CO., LTD.**
**Tokyo 100-8321 (JP)**

(72) Inventors:
• **FUKUDA, Masahiko**
**2990293 (JP)**
• **INOUE, Kazuyoshi**
**2990293 (JP)**
• **EIDA, Mitsuru**
**2990293 (JP)**
• **HOSOKAWA, Chishio**
**2990293 (JP)**

(74) Representative: **Gille Hrabal Struck Neidlein Prop Roos**
**Brucknerstrasse 20**
**40593 Düsseldorf (DE)**

(54) **ORGANIC ELECTROLUMINESCENCE DISPLAY DEVICE**

(57)    An organic EL display including an organic EL device 2 and a barrier film 3 which seals the organic EL device 2 and includes a conductive film. An organic EL display including an organic EL device, a color conversion layer, and a barrier film which seals the color conversion layer and includes a conductive film. An organic EL display including an organic EL device 2 and a barrier film 3 which seals the organic EL device 2 and includes a stress reducing layer 3b.

FIG. 1

(a)

(b)

**Description**

TECHNICAL FIELD

The invention relates to an organic electroluminescent (EL) display suitable as consumer and industrial displays such as displays for portable telephones, PDAs, car navigation systems, monitors, TVs, and the like.

BACKGROUND ART

An organic EL display includes an organic EL device in which an emitting layer is provided between opposing electrodes. When a voltage is applied between the electrodes of the organic EL device, electrons injected from one of the electrodes and holes injected from the other electrode recombine in the emitting layer. An organic luminescent molecule in the emitting layer is excited to an excited state due to the recombination energy, and then returns to the ground state. The organic EL device emits light by taking out the energy released at this time.

The organic EL display formed using the organic EL device having the above emission principle is a completely solid-state device, exhibits excellent visibility, and allows a reduction in weight and thickness. Moreover, the organic EL display can be driven at a low voltage of only several volts. Accordingly, the organic EL display is expected to be used as a full-color display and has been extensively studied.

Since the organic EL display utilizes a highly active alloy material for the cathode, the cathode tends to become corroded or oxidized due to reaction with water or oxygen. An area in which light is not emitted ("dark spot") occurs when the cathode deteriorates. Dark spots also occur when the organic EL device is damaged by water or oxygen entering from the outside, volatile components produced from other constituent members, and the like.

Attempts have been made to prevent such a dark spot by providing a barrier film. In this case, the barrier properties deteriorate if a pinhole is formed in the barrier film. A protrusion on a substrate or foreign matter (1 $\mu$m or less in diameter) provided from the outside environment or produced during film formation is present at the center of the pinhole.

In order to ensure the barrier properties by eliminating the pinhole, it is necessary to increase the thickness of the barrier film to enclose the foreign matter.

However, it takes time to form a dense film to a large thickness, thereby resulting in poor mass productivity. Moreover, when forming a dense film (inorganic film) with excellent barrier properties to a large thickness, the internal stress of the film increases, whereby a decrease in barrier properties, delamination, or cracks may occur.

Therefore, since the barrier layer cannot be formed to a large thickness, sufficient barrier properties cannot be provided. Moreover, since a barrier layer formed on a color conversion substrate exhibits insufficient surface flatness, the flatness of the electrode of the organic EL device formed on the barrier layer decreases, whereby defective indication may occur.

Since chemicals are used when patterning the electrode of the organic EL device on the barrier layer, the barrier layer, must exhibit chemical resistance. However, since the barrier layer cannot be formed to a large thickness, the barrier layer exhibits insufficient chemical resistance.

In patent document 1, a flattening layer with a large thickness is formed as the barrier film by applying an epoxy resin by spin coating or screen printing. However, although flattening is effected, since the flattening layer is formed in air, not a vacuum system, the resin layer adsorbs water, whereby the device deteriorates due to water.

Patent document 2 discloses an organic material (e.g. cycloolefin polymer or polyethylene) from which a film can be formed by vacuum deposition. Patent document 3 discloses a plasma-polymerized film (using a heterocyclic compound as a monomer).

Even if flattening is effected by the above films, they exhibit poor barrier properties. Therefore, since water enters through the side of the film, it is difficult to prevent deterioration of the device from the display edge.

Patent documents 4 and 5 disclose sealing layers for an organic EL device of a bottom-emission type organic EL display. The sealing layer disclosed in the patent document 4 is a conductive inorganic layer formed of a metal such as Ag, Al, or Au or an alloy such as TiN, ZnO, $SnO_2$, or $In_2O_3$. The sealing layer disclosed in the patent document 5 is a protective layer formed of $In_2O_3(ZnO)_x$ having a hexagonal layered structure. Patent document 6 discloses a sealing layers for a color conversion layer of a bottom-emission type organic EL display. The sealing layer disclosed in the patent document 6 is a high-resistivity oxide layer which is formed of the same elements as the adjacent low-resistivity oxide layer (lower electrode) of the organic EL device, but differs in oxygen content from the low-resistivity oxide layer.

When driving the displays disclosed in the patent documents 4 and 5 using a matrix drive, the sealing layer is not separated from the electrode of the organic EL device. When driving a display using a simple matrix drive, the electrodes of the organic EL device must be separated. When the separated electrodes are covered with the conductive sealing layer as in the displays disclosed in the patent documents 4 and 5, the electrodes are shortcircuited, whereby the displays cannot be driven. The sealing layer disclosed in the patent document 6 is a high-resistivity layer to achieve electrical separation. However, the high-resistivity oxide layer may also be patterned when chemically pattering the lower electrode having the same elemental composition as the high-resistivity oxide layer.

As technology of reducing the internal stress of the barrier film, a method has been disclosed which forms a stress reducing layer. In more detail, an organic material with a small Young's modulus such as a silicone resin is used as a stress reducing material (e.g. patent document 7).

However, since water enters through the side, it is difficult to prevent deterioration of the device from the display edge.

Patent document 8 discloses an emitting device having a buffer layer containing silicon oxide or silicon nitride oxide as the main component.

Patent document 9 discloses an organic EL device in which a protective layer is formed by the atomic layer growth method and contains a stress reducing component for reducing stress occurring in the protective layer.

Patent document 10 discloses an organic EL device in which a protective film is an amorphous carbon nitride film or a stacked film of an amorphous carbon nitride film and an inorganic film.

The above patent documents disclose sealing the organic EL device by inserting a stress reducing layer in the bottom-emission type organic EL display (patent documents 9 and 10) and the top-emission type organic EL display (patent document 8), but do not disclose improving the sealing performance by means of thick-film sealing using a stress reducing layer.

[Patent Document 1] JP-A-2002-25765

[Patent Document 2] JP-A-2003-17244

[Patent Document 3] JP-A-2002-117973

[Patent document 4] JP-A-10-247587

[Patent Document 5] JP-A-2000-68560

[Patent Document 6] JP-A-2004-31242

[Patent Document 7] JP-A-2000-182780

[Patent Document 8] JP-A-2003-257657

[Patent Document 9] JP-A-2001-284042

[Patent Document 10] JP-A-2003-282237

DISCLOSURE OF THE INVENTION

The invention was achieved in view of the above-described problems. An object of the invention is to provide an organic EL display in which a barrier film is formed which exhibits excellent barrier properties, reduces dark spots, and has a thickness sufficient to ensure surface flatness and chemical resistance.

The inventors of the invention have conducted extensive studies in order to achieve the above object. As a result, the inventors have found that a thick barrier film with excellent barrier properties can be formed at a high film formation rate by forming the barrier film of a conductive film.

The inventors have also found that forming a barrier film which includes a barrier layer formed of an inorganic material with excellent barrier properties and a stress reducing layer formed of an inorganic substance which reduces the internal stress of the barrier layer allows the internal stress of the barrier layer to be reduced even when using the material with excellent barrier properties so that the thickness of the barrier film can be sufficiently increased.

According to the invention, the following organic EL displays can be provided.

1. An organic electroluminescent display comprising: an organic electroluminescent device; and a barrier film which seals the organic electroluminescent device and includes a conductive film.

2. An organic electroluminescent display comprising: an organic electroluminescent device; a color conversion layer which adjusts and/or converts color of light from the organic electroluminescent device; and a barrier film which seals the color conversion layer and includes a conductive film.

3. An organic electroluminescent display comprising: a supporting substrate; an organic electroluminescent device formed on the supporting substrate; and a barrier film which is formed on a side of the organic electroluminescent device opposite to the supporting substrate and/or between the organic electroluminescent device and the supporting substrate and includes a conductive film.

4. An organic electroluminescent display comprising in this order: a supporting substrate; a color conversion layer which adjusts and/or converts color of light from an organic electroluminescent device; a barrier film including a conductive film; and an organic electroluminescent device.

5. The organic electroluminescent display according to any one of 1 to 4, wherein the conductive film of the barrier film is separated from an electrode of the organic electroluminescent device on the barrier film side.

6. The organic electroluminescent display according to 5, comprising an insulating film provided between the conductive film and the electrode of the organic electroluminescent device on the barrier film side.

7. The organic electroluminescent display according to 6, wherein the insulating film is formed of at least one material selected from an oxide, nitride, oxynitride, and chalcogenide.

8. The organic electroluminescent display according to any one of 1 to 7, wherein the conductive film is formed of a material differing from that of an electrode of the organic electroluminescent device on the barrier film side.

9. The organic electroluminescent display according to any one of 1 to 8, wherein the conductive film is formed of a noncrystalline material.

10. The organic electroluminescent display according to any one of 1 to 9, wherein the insulating film is formed of at least one material selected from an oxide, nitride, oxynitride, carbide, boride, and chalcogenide.

11. The organic electroluminescent display according to any one of 1 to 10, wherein the conductive film is formed of a compound containing at least one element selected from In, Zn, Sn, W, Zr, and Ta.

12. The organic electroluminescent display according to any one of 1 to 11, wherein the conductive film has a specific resistivity of $10^8$ $\Omega \cdot$cm or less.

13. The organic electroluminescent display according to any one of 1 to 12, wherein the supporting substrate is a plastic substrate.

14. The organic electroluminescent display according to any one of 1 to 13, wherein the barrier film is formed by vapor deposition.

15. The organic electroluminescent display according to 14, wherein the vapor deposition is sputtering.

16. The organic electroluminescent display according to any one of 1 to 15, wherein the organic electroluminescent display is an active drive type display, and the conductive film is electrically connected with an electrode of the organic electroluminescent device on the barrier film side.

17. An organic electroluminescent display comprising: an organic electroluminescent device; and a barrier film which seals the organic electroluminescent device and includes a stress reducing layer.

18. An organic electroluminescent display comprising: an organic electroluminescent device; a color conversion layer which adjusts and/or converts color of light from the organic electroluminescent device; and a barrier film which seals the color conversion layer and includes a stress reducing layer.

19. An organic electroluminescent display comprising: a supporting substrate; an organic electroluminescent device formed on the supporting substrate; and a barrier film which is formed on a side of the organic electroluminescent device opposite to the supporting substrate and/or between the organic electroluminescent device and the supporting substrate and includes a stress reducing layer.

20. An organic electroluminescent display comprising in this order: a supporting substrate; a color conversion layer which adjusts and/or converts color of light from an organic electroluminescent device; a barrier film including a stress reducing layer; and an organic electroluminescent device.

21. The organic electroluminescent display according to any one of 17 to 20, wherein the barrier film including a stress reducing layer is formed by vapor deposition.

22. The organic electroluminescent display according to 21, wherein the vapor deposition is sputtering or chemical vapor deposition (CVD).

23. The organic electroluminescent display according to any one of 17 to 22, wherein the barrier film including a stress reducing layer contains an inorganic metal compound. 24. The organic electroluminescent display according to 23, wherein the inorganic metal compound is an oxide, nitride, carbide, oxynitride, oxycarbide, or carbide nitride.

25. The organic electroluminescent display according to 23, wherein the inorganic metal compound is a compound of the following formula (1),

$$M^1uM^2vNxOyCz \qquad (1)$$

wherein $M^1$ and $M^2$ represent different metal elements, u and v satisfy $0 \leq u$, $v \leq 1$, and x, y, and z satisfy $0 \leq x$, y, z when u+v=1, provided that x>0.6 and y+z<0.2 are satisfied for the barrier layer, and x<0.2 and y+z>0.6 are satisfied for the stress reducing layer.

26. The organic electroluminescent device according to 23, wherein the inorganic metal compound is a compound of the following formula (2),

$$M^1M^2 \ ... \ M^nO \qquad (2)$$

wherein $M^1$, $M^2$, ..., and $M^n$ represent different metal elements, and n represents an integer of 2 or more for the barrier layer and represents 1 for the stress reducing layer.

27. The organic electroluminescent display according to any one of 24 to 26, wherein a metal of the inorganic metal compound includes at least one element selected from Si, Al, and Zn.

28. The organic electroluminescent display according to any one of 17 to 20, wherein the barrier film including a stress reducing layer is an amorphous film containing carbon.

29. The organic electroluminescent display according to any one of 17 to 28, wherein the barrier film including a stress reducing layer has an absolute value of internal stress of 200 MPa or less.

30. The organic electroluminescent display according to any one of 17 to 29, wherein the supporting substrate is a plastic substrate.

According to the invention, organic EL displays exhibiting the following effects can be obtained.

1. A film exhibiting improved gas barrier properties can be obtained by using a conductive inorganic film as the barrier film and increasing the thickness of the barrier film.

2. Since the conductive inorganic film allows the formation rate to be increased in comparison with the case of forming an SiOx or SiON film, which has been used as the barrier film, by sputtering, the conductive inorganic film is suitable for mass production.

3. Since occurrence of pinholes, delamination of the barrier film, formation of cracks, and the like can be suppressed by increasing the thickness of the barrier film by combining the barrier layer formed of an inorganic material with excellent barrier properties and the stress reducing layer, a film exhibiting improved gas barrier properties can be obtained.

In the organic EL display according to the invention in which the above barrier film is formed, a reduction in the emission display area or expansion of dark spots can be suppressed even when continuously driving (displaying) the organic EL display.

Moreover, since the surface flatness and the chemical resistance of the barrier layer are improved, the performance of the organic EL device formed on the barrier layer can be improved. Therefore, an organic EL display exhibiting excellent durability can be obtained.

Since the barrier film exhibits a high light transmittance, the barrier film can also be suitably used for a top-emission type organic EL display.

BRIEF DESCRIPTION OF THE DRAWINGS

FIG. 1 is a view illustrating an organic EL display according to a first embodiment of the invention.
FIG. 2 is a view illustrating an organic EL display according to a second embodiment of the invention.
FIG. 3 is a view illustrating an organic EL display according to a third embodiment of the invention.
FIG. 4 is a view illustrating an organic EL display according to a fourth embodiment of the invention.
FIG. 5 is a view illustrating another organic EL display according to the fourth embodiment of the invention.
FIG. 6 is a view illustrating yet another organic EL display according to the fourth embodiment of the invention.
FIG. 7 is a view illustrating an organic EL display according to a fifth embodiment of the invention.
FIG. 8 is a view illustrative of a method of determining the direction of the internal stress of an inorganic material film.
FIG. 9 is a view illustrating polysilicon TFT formation steps.
FIG. 10 is a circuit diagram illustrating an electric switch connection structure including a polysilicon TFT.
FIG. 11 is a planar perspective view illustrating an electric switch connection structure including a polysilicon TFT.

BEST MODE FOR CARRYING OUT THE INVENTION

First embodiment

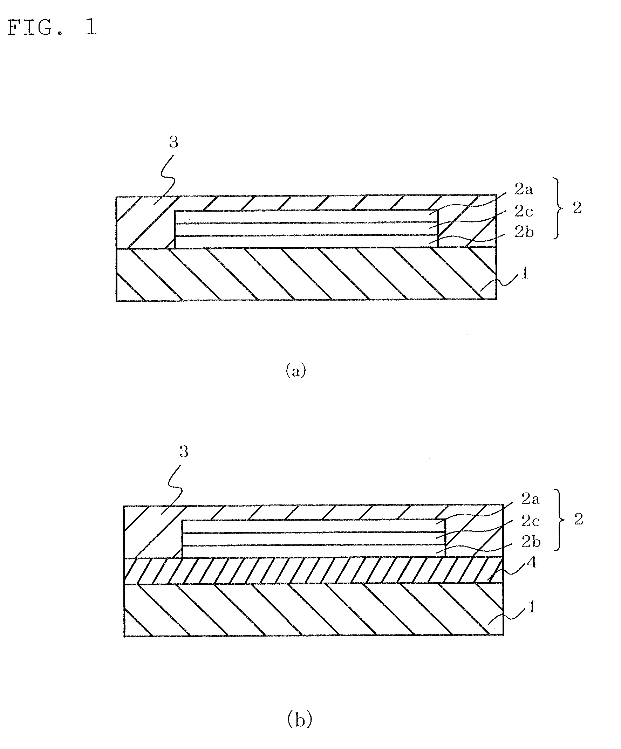

FIGS. 1(a) and 1(b) illustrate an organic EL display according to one embodiment of the invention.
In the organic EL display shown in FIG. 1, an organic EL device 2 and a barrier film 3 are formed on a supporting substrate 1. The organic EL device 2 includes a first electrode 2a, a second electrode 2b opposite to the first electrode 2a, and an emitting layer 2c provided between the first electrode 2a and the second electrode 2b. This organic EL display is a top-emission active-drive type display. Since this organic EL display is a top-emission type display, the first electrode 2a must transmit light. Accordingly, a transparent electrode is used as the first electrode 2a.
The barrier film 3 protects the organic EL device 2 from water, oxygen, and the like entering from the outside. Specifically, the barrier film 3 functions as a sealing material for the organic EL device.

In this embodiment, the barrier film 3 is formed of a conductive film. The conductive film preferably has a specific resistivity of $10^8$ Ω·cm or less.
As examples of the conductive compound forming the conductive film, metal oxides can be given. As specific examples of the metal oxides, In oxide, Sn oxide, Zn oxide, In-Sn oxide, In-Zn oxide, In-Zn-Sn oxide, and compounds obtained by adding a dopant to these oxides can be given. InxOy, InxZnyOz, ZnxOy (0<x<2.1, 0<y<3.3, 0<z<3.3), and compounds obtained by adding Sn, Al, Sb, Ga, or the like to these compounds in an amount of 0.2 to 40 at% are preferable. Particularly preferred compounds include ITO (In oxide doped with Sn), IZO (In-Zn mixed oxide), ATO (Sn oxide doped with Sb), AZO (Zn oxide doped with Al), and GZO (Zn oxide doped with Ga).

A compound obtained by adding Al, Ta, Mg, rare earth metal, Ti, Ni, Ir, Zr, or W to In oxide, Sn oxide, Zn oxide, In-Sn oxide, In-Zn oxide, or In-Zn-Sn oxide is also preferable.

As other examples of the conductive compound, a nitride, carbide, boride, and chalcogenide can be given. Specific examples include TiN, ZrN, LaB, ZnSe, and ZnS (composition of these compounds may deviate from a normal composition).

It is preferable that the conductive compound of the barrier film 3 be a substance differing from the first electrode 2a of the organic EL device 2. For example, the conductive compound of the barrier film 3 may be a noncrystalline substance, and the first electrode 2a of the organic EL device 2 may be a crystalline substance.

The barrier film 3 according to this embodiment may be formed by vapor deposition. As examples of vapor deposition, sputtering such as DC sputtering, DC magnetron sputtering, RF sputtering, RF magnetron sputtering, facing target sputtering, and ECR sputtering, vacuum evaporation such as resistive heating and electron-beam heating, ion plating, chemical vapor deposition (CVD), and the like can be given. The barrier film is preferably formed by sputtering which allows various films to be easily formed by changing the composition of the target.

When forming the barrier film by sputtering, since the barrier film 3 is formed of the conductive compound, a conductive target may be used. The conductive target can be sputtered using a DC power supply, whereby sputtering continuously occurs in comparison with radio-frequency (RF) sputtering (sputtering occurs when a target is negative). Moreover, since the amount of current supplied can be increased, the deposition output and the deposition rate are increased. This allows the thickness of the barrier film to be easily increased, whereby mass productivity can be improved.

As shown in FIG. 1(b), a second barrier film 4 may be provided between the supporting substrate 1 and the organic EL device 2. In particular, when the supporting substrate 1 is a plastic film, water or gas components produced from the plastic film can be confined or water or oxygen passing through the plastic film can be blocked by providing the barrier film 4 on the supporting substrate 1.

Second embodiment

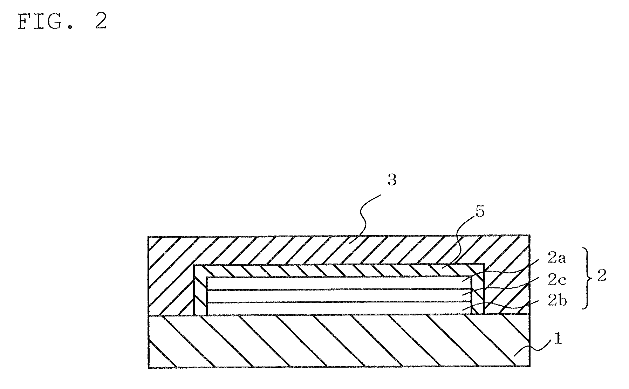

FIG. 2 illustrates an organic EL display according to a second embodiment of the invention.

The organic EL display illustrated in FIG. 2 is a bottom-emission passive-drive type display. An electrode pattern is necessary for the passive-drive type display. Therefore, the first electrode 2a of the organic EL device 2 must be separated from the barrier film 3. In this embodiment, an insulating film 5 is provided in order to separate the barrier film 3 from the electrode 2a of the organic EL device on the side of the barrier film. Since this organic EL display is a bottom-emission type display, the first electrode 2a need not transmit light. Accordingly, a metal electrode may be used as the first electrode 2a.

Since the organic EL display according to the first embodiment is an active-drive type display, the electrode is a common electrode and need not be patterned. Therefore, it is not necessary to provide an intermediate layer (insulating material) which separates the barrier film 3 from the electrode 2a of the organic EL device on the side of the barrier film. Note that an intermediate layer may be provided.

As examples of the insulating inorganic substance forming the insulating film 5, a metal oxide, nitride, oxynitride, and chalcogenide can be given. Specific examples include SiOx, SiOxNy, SiNx (0<x<2.2, 0<y<2.2), AlOx, AlOxNy, AlNx (0<x<2.2, 0<y<2.2), and the like. The insulating film 5 preferably has a specific resistivity of $10^{15}$ $\Omega \cdot$cm or more.

Third embodiment

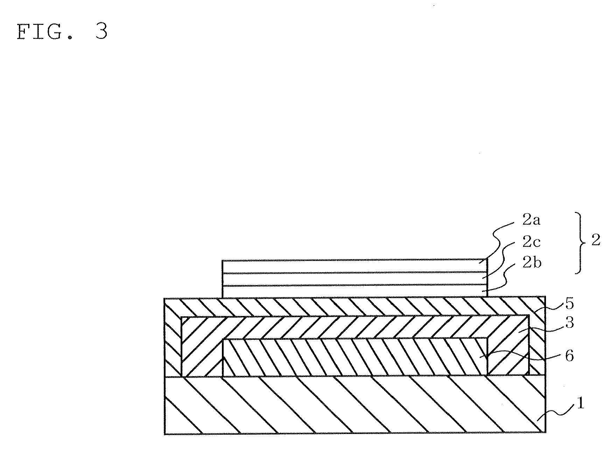

FIG. 3 illustrates an organic EL display according to a third embodiment of the invention.

In the organic EL display illustrated in FIG. 3, a color conversion layer 6, the barrier film 3 formed of a conductive film, the insulating film 5, and the organic EL device 2 are formed on the supporting substrate 1.

This organic EL display is a bottom-emission passive-drive type display. Accordingly, since an electrode pattern is necessary in the same manner as in the second embodiment, the second electrode 2b of the organic EL device 2 must be separated from the barrier film 3. The insulating film 5 is provided for this purpose. Since this organic EL display is a bottom-emission type display, the second electrode 2b must transmit light. Accordingly, a transparent electrode is used as the second electrode 2b.

Water or gas components produced from the color conversion layer 6 are confined therein by the barrier film 3, whereby the organic EL device 2 is protected.

The materials and the production methods for the barrier film 3 and the insulating film 5 are the same as described in the first and second embodiments. The insulating film 3b preferably has a transmittance of 50% or more.

In this embodiment, the barrier film 3 is formed on the color conversion layer 6. Note that the barrier film 3 may also be formed on the organic EL device 2 in order to seal the organic EL device 2. The barrier film 3 may also be formed between the supporting substrate 1 and the color conversion layer 6.

The organic EL display according to this embodiment is a bottom-emission type display in which the color conversion layer 6 adjusts and/or converts light from the organic EL device 2, and the light is outcoupled from the supporting substrate 1, as described above. The organic EL display according to this embodiment may be a top-emission type display in which the organic EL device 2 and the color conversion layer 6 are formed on the supporting substrate 1, and light is outcoupled from the side opposite to the supporting substrate 1. In this case, the barrier film 3 may be formed between the supporting substrate and the organic EL device, between the organic EL device and the color conversion layer, or on the color conversion layer in order to protect the organic EL device 2.

Fourth embodiment

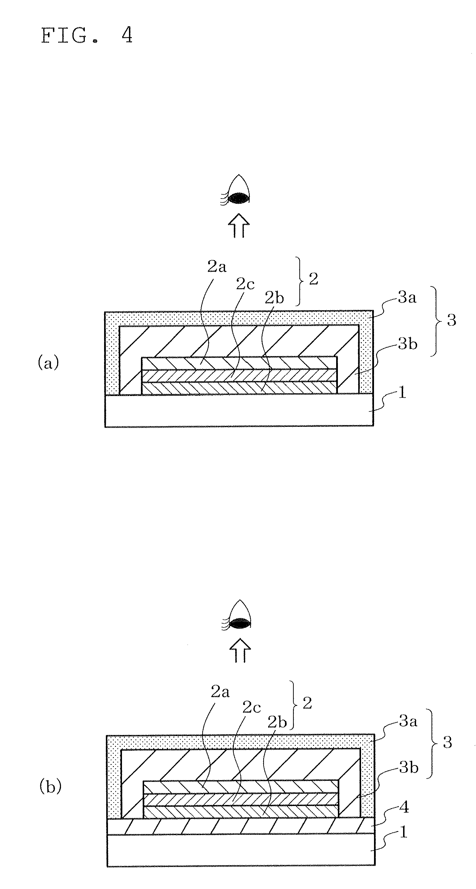

FIGS. 4(a) and 4(b) illustrate an organic EL display according to a fourth embodiment of the invention. In the organic EL display illustrated in FIG. 4, the organic EL device 2 and the barrier film 3 are formed on the supporting substrate 1. The organic EL device 2 is the same as in the above-described embodiments. This organic EL display is a top-emission active-drive type display. Since this organic EL display is a top-emission type display, the first electrode 2a must transmit light. Accordingly, a transparent electrode is used as the first electrode 2a. The barrier film 3 protects the organic EL device 2 from water, oxygen, and the like entering from the outside. Specifically, the barrier film 3 functions as a sealing material for the organic EL device 2.

According to the invention, since the barrier film 3 has a stacked structure including a barrier layer 3a and a stress reducing layer 3b, even if a dense inorganic material with excellent barrier properties is used for the barrier layer 3a, the internal stress of the barrier layer 3a can be reduced. This prevents cracks or delamination of the barrier film 3 due to the internal stress.

As shown in FIG. 4(b), the second barrier film 4 may be provided between the supporting substrate 1 and the organic EL device 2. In particular, when the supporting substrate 1 is a plastic film, water or gas components produced from the plastic film can be confined or water or oxygen passing through the plastic film can be blocked by providing the barrier film 4 on the supporting substrate 1.

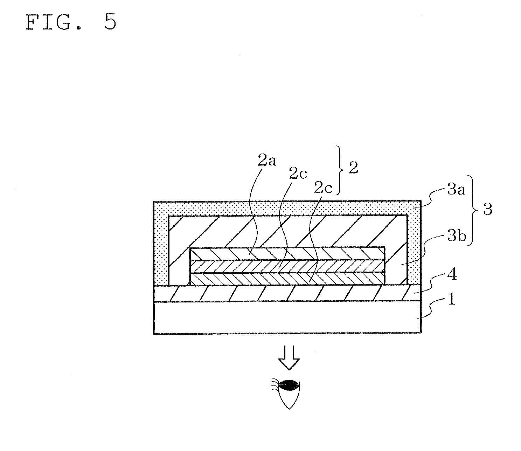

The organic EL display according to this embodiment is a top-emission type display in which light is outcoupled from the side opposite to the supporting substrate 1. As illustrated in FIG. 5, the organic EL display may be a bottom-emission type display in which light is outcoupled from the supporting substrate 1. In this case, the barrier film 4 may be formed on the organic EL device or between the supporting substrate and the organic EL device in order to protect the organic EL device 2.

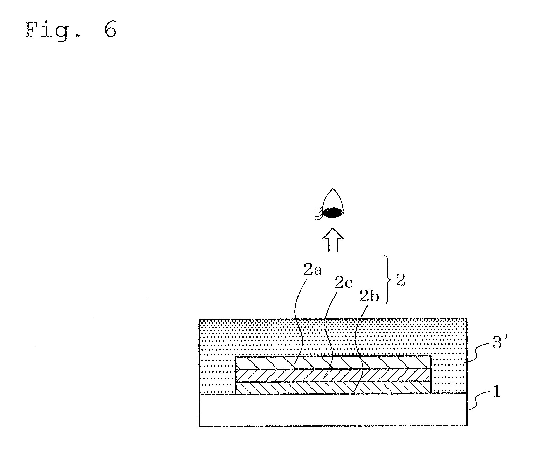

The interface between the barrier layer 3a and the stress reducing layer 3b need not be definite. FIG. 6 is a schematic cross-sectional view of another organic EL display according to this embodiment. A barrier film 3' of this organic EL display is formed of inorganic materials which gradually differ in properties upward from the surface in contact with the organic EL device 2. Specifically, a region which mainly contains an inorganic material functioning as a stress reducing layer is formed near the surface in contact with the organic EL device 2 of the barrier film 3', and a region which mainly contains an inorganic material with higher barrier properties is formed toward the outside.

Fifth embodiment

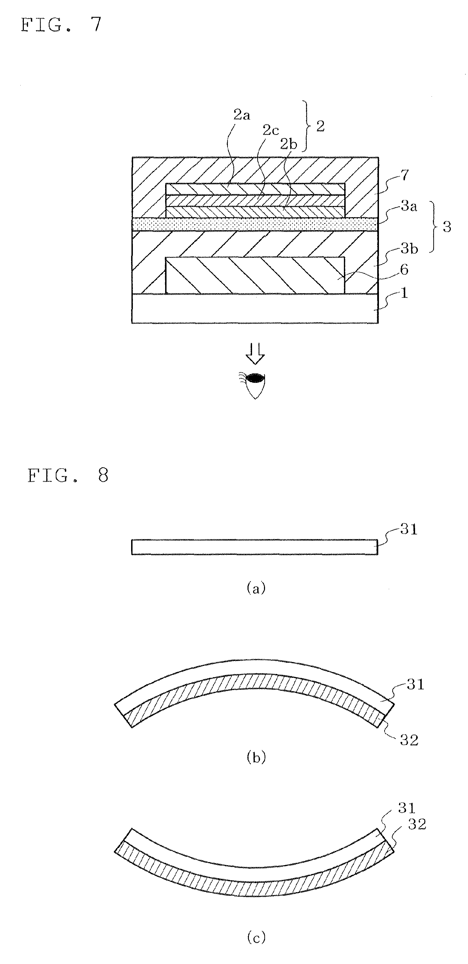

FIGS. 7 illustrates an organic EL display according to a fifth embodiment of the invention. This organic EL display is a bottom-emission passive-drive type display. In this organic EL display, the color conversion layer 6 is formed on the supporting substrate 1, and is covered with the barrier film 3 which is the same as that in the fourth embodiment. The organic EL device 2 and a sealing barrier film 7 that prevents entrance of water or the like from the outside into the device are formed on the barrier film 3.

In this organic EL display, leakage of water or gas components contained in the color conversion layer 6 can be reliably prevented. Therefore, since deterioration of each section member of the organic EL device can be reduced, a reduction in the emission display area or expansion of dark spots occurring when continuously driving (displaying) the organic EL device can be suppressed, whereby an organic EL display exhibiting excellent durability can be obtained. Moreover, since the thickness of the barrier film can be increased by inserting the stress reducing layer, the surface flatness of the barrier layer is improved. Therefore, the flatness of the electrode of the organic EL device formed on the barrier layer is improved so that emission lines of the EL device and the like can be suppressed, whereby the display characteristics are improved.

In this embodiment, the barrier film 3 is formed on the color conversion layer 6. Note that the barrier film 3 may also be formed on the organic EL device 2 in order to seal the organic EL device 2. The barrier film 3 may also be formed between the supporting substrate 1 and the color conversion layer 6.

The organic EL display according to this embodiment is a bottom-emission type display in which the color conversion layer 6 adjusts and/or converts light from the organic EL device 2, and the light is outcoupled from the supporting substrate 1, as described above. The organic EL display according to this embodiment may be a top-emission type display in which the organic EL device 2 and the color conversion layer 6 are formed on the supporting substrate 1, and light is outcoupled from the side opposite to the supporting substrate 1. In this case, the barrier film 3 may be formed between the supporting substrate and the organic EL device, between the organic EL device and the color conversion layer, or on the color conversion layer in order to protect the organic EL device 2.

The barrier film used in the invention is described below.

As the inorganic materials for the barrier layer and the stress reducing layer forming the barrier film, an oxide, nitride, carbide, oxynitride, oxycarbide, and nitride carbide of a metal (alloy) may be used.

Inorganic metal compounds of AOx, ANx, ACx, AOxNy, AOxCy, and ACxNy (wherein A is a metal or an alloy, 0<x<2.2, and 0<y<2.2) are preferable.

The barrier layer and the stress reducing layer are preferably formed of compounds of the following formula (1).

$$M^1uM^2vNxOyCz \qquad (1)$$

wherein $M^1$ and $M^2$ represent different metal elements, u and v satisfy $0 \leq u, v$, and x, y, and z satisfy $0 \leq x, y, z$ when u+v=1, provided that x>0.6 and y+z<0.2 are satisfied for the barrier layer, and x<0.2 and y+z>0.6 are satisfied for the stress reducing layer.

A highly dense film is easily formed using a compound of the formula (1) with a high nitrogen (N) content. Therefore, since the resulting film exhibits excellent water/gas barrier properties, such a compound is suitable as the material for the barrier layer.

A film with small internal stress is easily formed using a compound of the formula (1) with a low nitrogen (N) content, although the density of the film is decreased. Therefore, such a compound is suitable as the material for the stress reducing layer.

For example, $Si_3N_4$ has a density of 3.1 g/cm$^3$ and forms a film which exhibits excellent barrier properties. $SiO_2$ has a density of 2.2 g/cm$^3$ and forms a film which exhibits reduced barrier properties but exhibits a small internal stress. SiOyNx has an intermediate density, of which the barrier properties and the internal stress can be adjusted by changing x and y.

It is also preferable that the metal oxide be a compound of the following formula (2).

$$M^1M^2 ... M^nO \qquad (2)$$

wherein $M^1$, $M^2$, ..., and $M^n$ represent different metal elements, and n represents an integer of 2 or more for the barrier layer and represents 1 for the stress reducing layer.

As preferred examples of the metals represented by M, Si, Al, Zn, Ti, and B can be given. As examples of the alloy, an alloy of Si and Zn, alloy of Si and Al, and alloy of Zn and Al can be given.

As the inorganic material, a carbon-containing amorphous compound such as diamond-like carbon or carbon nitride (CNx) may also be preferably used.

The inorganic materials used for the barrier layer and the stress reducing layer are selected taking into consideration the direction of the internal stress occurring when forming a film of the inorganic material.

FIG. 8 is a view illustrative of a method of evaluating the direction of the internal stress of the inorganic material.

The direction in which the internal stress occurs is defined by the direction of warping which occurs when forming an inorganic material layer 32 on a measurement substrate 31. A case where concave warping occurs in the direction of the surface on which the inorganic material layer 32 is formed is defined as a tensile stress and denoted by "+" (FIG. 8(b)). A case where convex warping occurs in the direction of the surface on which the inorganic material layer 32 is formed is defined as a compressive stress and denoted by "-" (FIG. 8(c)).

An Si substrate or the like may be used as the measurement substrate 31.

The internal stress is calculated by optically detecting a change in warping of the substrate before and after forming the inorganic material layer 32 on the substrate. In more detail, the internal stress σ of a thin film may be calculated using the following Stoney expression.

$$\sigma = \frac{E \cdot h^2}{6(1-\nu) R \cdot t}$$

where, $E/(1-\nu)$ is the biaxial modulus of elasticity of the measurement substrate, h is the thickness of the measurement substrate, t is the thickness of the formed thin film, and R is the radius of curvature of warping of the measurement substrate due to film formation.

When the length of the sample is L and the flexure is $\delta$, R is geometrically expressed as $R=L^2/(2\delta)$. Therefore, the above expression can be transformed as follows.

$$\sigma = \frac{E \cdot h^2 \cdot \delta}{3 \ (1-\nu) \ L^2 \cdot t}$$

The internal stress $\sigma$ can be measured by optically detecting the flexure $\delta$.

This measurement method is described in "Stress/strain measurement evaluation technique" (published by Sougou Gijutsu Center), for example.

In the invention, the absolute value of the total internal stress of the barrier film (i.e. barrier layer and stress reducing layer) is preferably 200 MPa or less, and particularly preferably 50 MPa or less. If the absolute value exceeds 200 MPa, delamination or cracks in the barrier film tends to occur.

In order to achieve an absolute value of 200 MPa or less, the internal stress of the entire barrier film may be reduced by combining a film having a compressive stress and a film having a tensile stress or combining films with a small internal stress irrespective of the compressive stress and the tensile stress, for example.

The thickness of the barrier film is 300 nm to 2 $\mu$m, and preferably 500 nm to 1.5 $\mu$m. If the thickness of the barrier film is less than 300 nm, since foreign matter cannot be embedded, dark spots may not be sufficiently suppressed. If the thickness of the barrier film exceeds 2 $\mu$m, it takes time to form the barrier film, thereby resulting in poor productivity.

The thicknesses of the barrier layer and the stress reducing layer forming the barrier film are appropriately adjusted depending on the internal stress value and the like.

The barrier film may be formed by vapor deposition. As examples of vapor deposition, sputtering such as DC sputtering, DC magnetron sputtering, RF sputtering, RF magnetron sputtering, facing target sputtering, and ECR sputtering, vacuum evaporation such as resistive heating and electron-beam heating, ion plating, plasma chemical vapor deposition (CVD), and the like can be given.

When forming the barrier film by sputtering, Ar, He, or the like may be used as an inert gas, and the above-mentioned inorganic material may be used as a target.

When forming the barrier film by reactive DC sputtering, Ar, He, or the like may be used as an inert gas, $N_2$, $O_2$, $NH_3$, $H_2$, or $CH_4$ may be used as a reactive gas, and various metals (e.g. Si, Al, or Si-Al) may be used as a target.

When forming the barrier film by plasma CVD, $SiH_4$ (silane), $Si_2H_6$ (disilane), or $Si(OC_2H_5)_4$ (tetraethoxysilane (TEOS)) may be used as an Si source, $O_2$ may be used as an O source, $N_2$ or $NH_3$ may be used as an N source, $CO_2$ or CO may be used as a C source, $CO_2$ or CO may be used as a C-O source, and NO, $NO_2$, or $N_2O$ may be used as an N-O source.

The supporting substrate, the organic EL device, and the color conversion layer used in the above-described first and second inventions are not particularly limited. These members are described below.

Materials for the supporting substrate include glass plates, metal plates, ceramic plates or plastic plates such as polycarbonate resins, acrylic resins, vinyl chloride resins, polyethylene terephthalate resins, polyimide resins, polyester resins, epoxy resins, phenol resins, silicon resins, fluorine-containing resins and polyethersulfone resins.

The organic EL device includes an emitting layer and a first and second electrode which hold the emitting layer therebetween. The first or second electrode may be an anode or cathode.

Examples of luminous materials of the emitting layer include only one or combinations of two or more selected from p-quaterphenyl derivatives, p-quinquephenyl derivatives, benzodiazole compounds, benzimidazole compounds, benzoxazole compounds, metal-chelated oxynoid compounds, oxadiazole compounds, styrylbenzene compounds, distyrylpyrazine derivatives, butadiene compounds, naphthalimide compounds, perylene derivatives, aldazine derivatives, pyraziline derivatives, cyclopentadiene derivatives, pyrrolopyrrole derivatives, styrylamine derivatives, coumarin compounds, aromatic dimethylidyne compounds, metal complexes having an 8-quinolinol derivative as a ligand, and polyphenyl compounds.

Other than the emitting layer, an electron injecting layer, electron transporting layer, hole transporting layer, hole injecting layer and so on may be formed.

It is preferred to use a material having a large work function for an anode, for example, one or combinations of two or more selected from indium tin oxide (ITO), indium zinc oxide (IZO), copper indium (CuIn), tin oxide ($SnO_2$), zinc oxide (ZnO), antimony oxide ($Sb_2O_3$, $Sb_2O_4$, $Sb_2O_5$) and aluminum oxide ($Al_2O_3$).

It is preferred to use a material having a small work function for a cathode, for example, one or combinations of two or more selected from sodium, sodium-potassium alloys, cesium, magnesium, lithium, magnesium-silver alloys, aluminum, aluminum oxide, aluminum-lithium alloys, indium, rare earth metals, mixtures of these metals and organic luminescence medium materials, and mixtures of these metals and electron injecting layer materials.

As a color conversion layer adjusting and/or converting a luminescent color of organic EL device, the following three cases can be given: (i) only a color filter, (ii) only a fluorescent medium and (iii) a combination of a color filter and a fluorescent medium.

The color filter is to decompose and cut light to adjust color and improve contrast.

Examples of materials for the color filter include the following dyes or solid objects in which the dye is dissolved or dispersed in a binder resin.

Red (R) dye:

It is possible to use only one or a mixture of at least two and more selected from perylene pigments, lake pigments, azo pigments, quinacridone pigments, anthraquinone pigments, anthracene pigments, isoindorine pigments, isoindorinone pigments, diketopyrrolopyrrole pigments and so on.

Green (G) dye:

It is possible to use only one or a mixture of at least two and more selected from halogen-multisubstituted phthalocyanine pigments, halogen-multisubstituted copper phthalocyanine dyes, triphenylmethane basic dyes, azo pigments, isoindorine pigments, isoindorinone pigments and so on.

Blue (B) dye:

It is possible to use only one or a mixture of at least two and more selected from copper phthalocyanine dyes, indanthrone pigments, indophenol pigments, cyanine pigments and dioxazin pigments and so on.

The binder resin for the color filter is preferably a material having transparency (transmittance in the visible light region: 50% or more). Examples thereof are transparent resins (polymers) such as polymethyl methacrylate, polyacrylate, polycarbonate, polyvinyl alcohol, polyvinyl pyrrolidone, hydroxyethylcellulose, and carboxymethylcellulose. It can be used as one or a mixture of two or more thereof.

The fluorescent medium has a function of absorbing luminescence of the organic EL element to give fluorescence having a longer wavelength.

The constituent material of the fluorescent medium is made of, for example, a fluorescent dye and a resin, or only a fluorescent dye. The fluorescent dye and the resin may be solid where a fluorescent dye is dissolved or dispersed in a pigment resin and/or a binder resin.

Specific examples of the fluorescent dye will be described. Examples of a fluorescent dye for changing near-ultraviolet to violet light emitted from an organic EL device to blue light include stylbene dyes such as 1,4-bis(2-methylstyryl)benzene (Bis-MBS) and trans-4,4'-diphenylstylbene (DPS); and coumarin dyes such as 7-hydroxy-4-methylcoumarin (coumarin 4).

Examples of a fluorescent dye for changing blue, bluish green or white light emitted from an organic EL device to green light include coumarin dyes such as 2,3,5,6-1H,4H-tetrahydra-8-trifluoromethylquinolidino(9,9a,1-gh)coumarin (coumarin 153), 3-(2'-benzothiazolyl)-7-diethylaminocoumarin (coumarin 6) and 3-(2'-benzimidazolyl)-7-N,N-diethylaminocoumarin (coumarin 7); Basic Yellow 51, which is a coumarin type dye; and naphthalimide dyes such as Solvent Yellow 11 and Solvent Yellow 116.

Examples of a fluorescent dye for changing blue to green light or white light emitted from an organic EL device to orange to red light include cyanine dyes such as 4-dicyanomethylene-2-methyl-6-(p-dimethylaminostyryl)-4H-pyran (DCM); pyridine dyes such as 1-ethyl-2-(4-(p-dimethylaminophenyl)-1,3-butadienyl)-pyridinium-perchlorate (pyridine 1); rhodamine dyes such as Rhodamine B and Rhodamine 6G; oxadine dyes; basicviolet 11; and coumarin 6.

The same binder resin used for the color filter can be used.

For the other constituent members such as a supporting substrate, an organic EL device and a color conversion layer, those described in WO 02/017689, WO 03/043382, WO 03/069957, PCT application JP 03/02798, Japanese patent application 2002-301852 and so on can be used.

EXAMPLES

Example 1

In this example, TFT (not shown), an organic EL device 2 and a barrier film 3 were formed on a supporting substrate 1 in this order to fabricate an organic EL display (top emission, TFT active type) illustrated in FIG. 1 (a).

(1) Formation of TFT

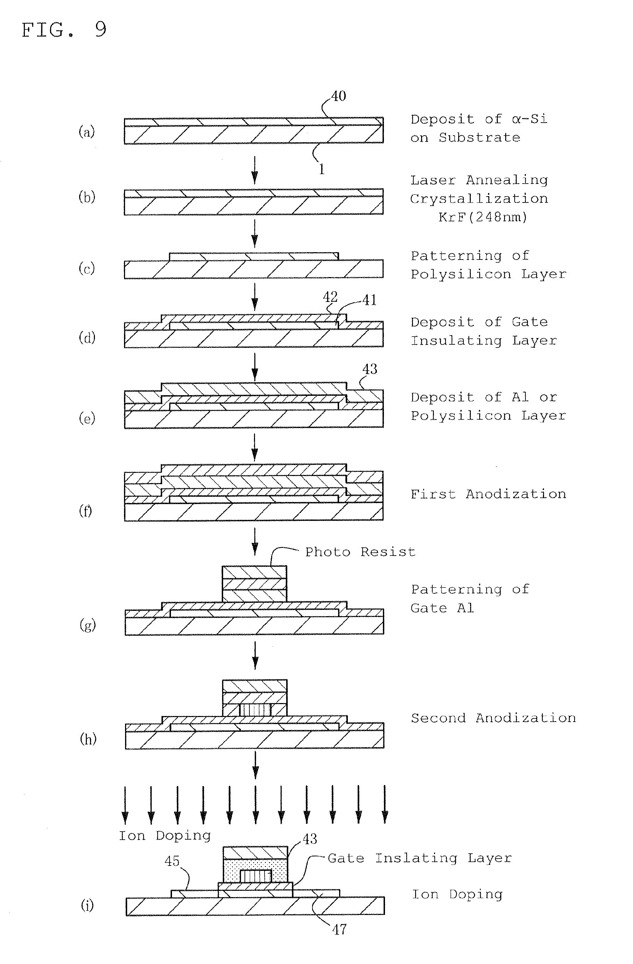

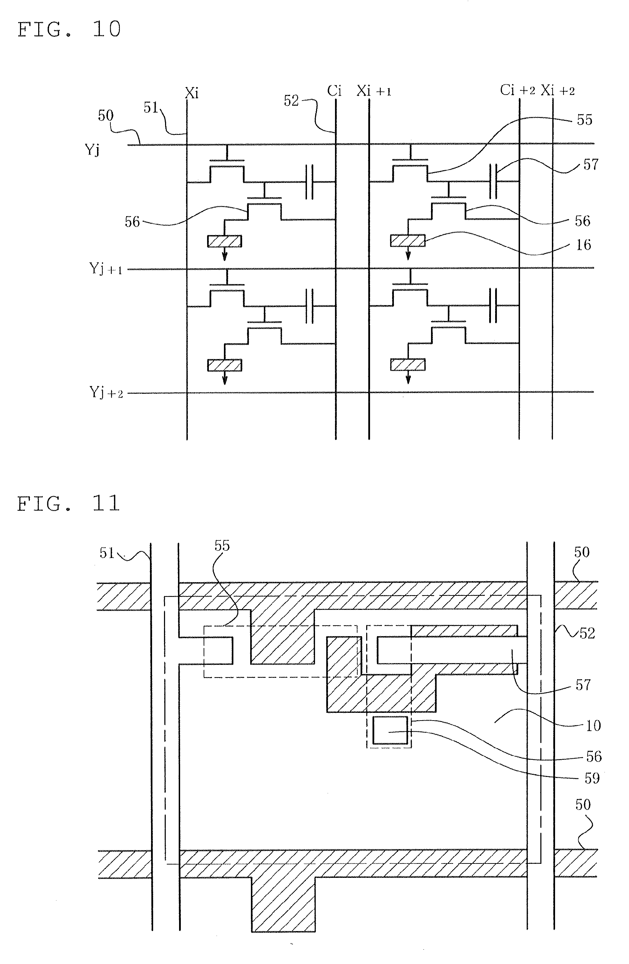

FIGS. 9 (a) to (i) are views illustrating polysilicon TFT formation steps. FIG. 10 is a circuit diagram illustrating an electric switch connection structure including a polysilicon TFT, and FIG. 11 is a planar perspective view illustrating an electric switch connection structure including a polysilicon TFT.

An $\alpha$-Si layer 40 was formed on a glass substrate 1 (OA2 glass manufactured by Nippon Electric Glass Co., Ltd.) having dimensions of $112\times143\times1.1$ mm by a method such as low pressure chemical vapor deposition (LPCVD) (FIG. 9(a)). Then, crystallization annealing was performed by applying an excimer laser such as a KrF (248nm) laser to the $\alpha$-Si layer 40 to form polysilicon (FIG. 9(b)). The polysilicon was patterned in the shape of islands by photolithography (FIG. 9(c)). An insulating gate material 42 was deposited on the surfaces of the island-shaped polysilicon 41 and the substrate 1 by chemical vapor deposition (CVD) or the like to form a gate oxide insulating layer 42 (FIG. 9(d)). After forming a gate electrode 43 by deposition or sputtering (FIG. 9(e)), the gate electrode 43 was patterned and anodic oxidation was performed (FIGS. 9(f) to 9(h)). Then, doped regions (active layer) were formed by ion doping (ion implantation) to form a source 45 and a drain 47 to obtain a polysilicon TFT (FIG. 9 (i)). The gate electrode 43 (and scan electrode 50 and bottom electrode of capacitor 57 shown in FIG. 10) was formed from Al, and the source 45 and the drain 47 of the TFT were of n$^+$-type.

After forming an interlayer insulator (SiO$_2$) having a thickness of 500 nm on the active layer by a CRCVD method, a signal electrode 51, a common electrode 52, and a capacitor upper electrode (Al) were formed, a source electrode of a second transistor (Tr2) 56 was connected with the common electrode, and the drain of a first transistor (Tr1) 55 was connected with the signal electrode (FIGS. 10 and 11). The TFT and the electrode were connected by appropriately opening the interlayer insulator SiO$_2$ by wet etching using hydrofluoric acid.

Next, Cr and ITO (indium tin oxide) were deposited by sputtering to thicknesses of 2000 angstroms and 1300 angstroms, respectively. A positive-type resist ("HPR204" manufactured by Fuji Film Arch Co., Ltd.) was applied to the substrate by spin coating, and ultraviolet rays were applied through a photomask for forming a $90\times320\mu$m dot-shaped pattern. The resist was then developed using a tetramethylammonium hydroxide (TMAH) developer and baked at 130°C to obtain a resist pattern.

The exposed ITO was etched using an ITO etchant containing 47% hydrobromic acid, and the Cr was etched using a ceric ammonium nitrate/perchloric acid aqueous solution ("HCE" manufactured by Nagase & Company, Ltd.). The resist was treated with a stripper containing ethanolamine as the major component ("N303" manufactured by Nagase & Company, Ltd.) to obtain a Cr/ITO pattern (anode).
In this step, the second transistor Tr2 56 and the lower electrode 10 were connected through an opening 59 (FIG. 11).

As a second interlayer insulator, a negative-type resist ("V259BK" manufactured by Nippon Steel Chemical Co., Ltd.) was applied by spin coating, irradiated with ultraviolet rays, and developed using a tetramethylammonium hydroxide (TMAH) developer. The resulting resist was baked at 180°C to form an interlayer insulator of an organic film which covered the Cr/ITO edge (ITO opening was $70\times200$ $\mu$m). (2) Fabrication of organic EL device

The substrate on which the interlayer insulator was formed was subjected to ultrasonic cleaning in pure water and isopropyl alcohol, dried by air blowing, and subjected to UV cleaning.
The TFT substrate was transferred to an organic deposition device (manufactured by ULVAC, Inc.) and secured on a substrate holder. Individual molybdenum heating boats were charged in advance with 4,4',4"-tris[N-(3-methylphenyl)-N-phenylamino]triphenylamine (MTDATA) and 4,4'-bis [N-(1-naphthyl)-N-phenylamino]biphenyl (NPD) as a hole injecting material, 4,4'-bis(2,2-diphenylvinyl)biphenyl (DPVBi) as a host of an emitting material, 1,4-bis[4-(N,N-diphenylaminostyrylbenzene)] (DPAVB) as a dopant, and tris(8-quinolinol)aluminum (Alq) and Li as an electron injecting material and a cathode. An IZO (mentioned above) target was placed in another sputtering vessel as a cathode lead electrode.

After reducing the pressure inside the vacuum chamber to $5\times10^{-7}$ torr, the layers from the hole injecting layer to the cathode were stacked as described below without breaking the vacuum.
As the hole injecting layer, MTDATA was deposited to a thickness of 160 nm at a deposition rate of 0.1 to 0.3 nm/sec and NPD was deposited to a thickness of 20 nm at a deposition rate of 0.1 to 0.3 nm/sec. As the emitting layer, DPVBi and DPAVB were codeposited to a thickness of 50 nm at deposition rates of 0.1 to 0.3 nm/sec and 0.03 to 0.05 nm/sec, respectively. As the electron injecting layer, Alq was deposited to a thickness of 20 nm at a deposition rate of 0.1 to 0.3 nm/sec. As the cathode, Alq and Li were codeposited to a thickness of 20 nm at deposition rates of 0.1 to 0.3 nm/sec and 0.005 nm/sec, respectively.

Then, the substrate was transferred to the sputtering vessel, and ITO was deposited to a thickness of 200 nm at a deposition rate of 0.1 to 0.3 nm/sec as the lead electrode of the cathode to obtain an organic EL device.

(3) Formation of barrier film

A barrier film was formed on the cathode of the organic EL device by DC magnetron sputtering using IZO as a target. The barrier film was formed to a thickness of 500 nm at a sputtering pressure of 0.2 Pa and a sputtering power of 0.7 kW. The deposition time was 50 minutes. Since it takes 250 minutes to form an $SiO_2$ film with the same thickness by RF magnetron sputtering using the same device, it is understood that the invention is suitable for mass production. After forming the barrier film as an EL sealing film, a glass lid was placed on the substrate through a UV-curable adhesive so that the organic EL device was completely covered, and bonded to the substrate by applying ultraviolet rays to prevent external physical contact.

The atomic composition of the IZO film was determined by X-ray photoelectron spectroscopy (XPS). The composition of the IZO film was (In/Zn/O=36/5/59) ($5 \times 10^{-4}$ $\Omega \cdot cm$).

(4) Reliability evaluation of organic EL display

An active organic EL display was produced in this manner. A DC voltage of 7 V was applied between the anode (ITO/Cr) and the cathode (ITO) (anode: (+), cathode: (-)). As a result, light was emitted from the intersecting point (pixel) of the electrodes. The barrier film (IZO) adhered to and was electrically connected with the cathode.

The organic EL display was subjected to a 85°C storage test for 500 hours, and the reduction rate of the emitting pixel area was measured using a microscope. The reduction rate was 2%. This indicates that an organic EL display exhibiting excellent durability was obtained.

```
Reduction rate (%) = (emitting pixel area before test -

emitting pixel area after test) × 100 / emitting pixel area before test
```

The number of dark spots (DS) with a diameter of 30 $\mu$m or more was measured in 4x4-mm areas at the center and the four corners of the display area (five points in total). The average number of dark spots was 0.2.

(5) Measurement of water vapor transmission rate

The water vapor transmission rate was measured in accordance with JIS K 7129. In more detail, the barrier film used in this example was formed on the upper surface of a polyethylene terephthalate (PET) film to obtain a sample. The water vapor transmission rate measured in accordance with the method described in JIS K 7129 was 0.001 g/m$^2 \cdot$24hr (measurement lower limit) or less. It was confirmed that a sufficient organic EL display performance was obtained.

Example 2

A barrier film was formed in the same manner as in Example 1 except that a mixed gas of oxygen (10%) and Ar was used as the introduced gas. The composition of the film was IZO (In/Zn/O=27/3/70) ($1 \times 10^8$ $\Omega \cdot cm$). The results of reliability evaluation are shown in Table 1.

Examples 3 to 8

An organic EL display was produced in the same manner as in Example 1 except that the barrier film was formed to have a composition given below. The reliability evaluation was conducted in the same manner as in Example 1. The results are shown in Table 1.

Example 3: ITO (In/Sn/O=37/3/60) ($7 \times 10^{-4}$ $\Omega \cdot cm$)
Example 4: IZWO (In/Zn/W/O=34.4/6.6/0.2/58.8) ($8 \times 10^{-4}$ $\Omega \cdot cm$)
Example 5: TiN (Ti/N=52/48) ($6 \times 10^{-3}$ $\Omega \cdot cm$)
Example 6: ZrC (Zr/C=60/40) ($8 \times 10^{-3}$ $\Omega \cdot cm$)
Example 7: LaB (La/B=55/45) ($7 \times 10^{-2}$ $\Omega \cdot cm$)
Example 8: ZnS (Zn/S=60/40) ($5 \times 10^{-2}$ $\Omega \cdot cm$)

Comparative Example 1

An organic EL display was produced in the same manner as in Example 1 except that the barrier film was formed by RF magnetron sputtering using $SiO_2$ as a target to a thickness of 500 nm at a sputtering pressure of 0.2 Pa and a sputtering power of 0.2 kW. The reliability evaluation was conducted in the same manner as in Example 1. The deposition time was 250 minutes. The atomic composition of the barrier film was Si/O=35/65.
The reduction ratio of the emitting pixel area was 50%. The durability of the organic EL display was significantly lower than that of the example. The number of dark spots (DS) after the reliability evaluation was several tens.

Example 9

An organic EL display was produced in the same manner as in Example 1 except that an insulating film was formed on the IZO barrier film (500 nm) by RF magnetron sputtering using an SiO target and $N_2$ gas to a thickness of 150 nm at a sputtering pressure of 0.2 Pa and a sputtering power of 0.2 kW. The reliability evaluation was conducted in the same manner as in Example 1. The results are shown in Table 1. The atomic composition of the IZO film was In/Zn/O=36/5/59, and the atomic composition of the SiON film was Si/N/O=50/40/10.

Example 10

An organic EL display was produced in the same manner as in Example 9 except for changing the configurations of the barrier film and the insulating film as given below. The reliability evaluation was conducted in the same manner as in Example 9. The results are shown in Table 1.
In this example, the insulating film (SiON) (150 nm) was formed and thereafter the conductive film (IZO) (500 nm) was formed. The atomic composition of the SiON film was Si/N/O=50/40/10, and the atomic composition of the IZO film was In/Zn/O=36/5/59.

Example 11

An organic EL display was produced in the same manner as in Example 9 except for changing the configurations of the barrier film and the insulating film as given below. The reliability evaluation was conducted in the same manner as in Example 9. The results are shown in Table 1.
In this example, a three-layer configuration was formed which was the insulating film (SiON) (Si/N/O=50/40/10) (150 nm), conductive film (barrier film) (IZO) (In/Zn/O=36/5/59) (500 nm), and insulating film (SiON) (Si/N/O=50/40/10) (150 nm).
As shown in Table 1, the barrier performance was improved in Examples 9 to 11 by increasing the film thickness using the conductive film and stacking the insulating film.

Example 12

In this example, an organic EL display (bottom emission, passive type) having layers illustrated in FIG. 2 was fabricated.

(1) Fabrication of passive type organic EL device

IZO (indium zinc oxide) was deposited by sputtering to a thickness of 200 nm on a supporting substrate (transparent substrate) (OA2 glass manufactured by Nippon Electric Glass Co., Ltd.) having dimensions of 102x133x1.1 mm.
A positive-type resist ("HPR204" manufactured by Fujifilm Olin Co., Ltd.) was applied to the substrate by spin coating, and ultraviolet rays were applied through a photomask so that a cathode lead portion and a 90-μm line and 20-μm gap stripe pattern were formed. The resist was then developed using a TMAH (tetramethylammonium hydroxide) developer and baked at 130°C to obtain a resist pattern.
The exposed IZO was etched using an IZO etchant (5% oxalic acid aqueous solution). The resist was treated with a stripper containing ethanolamine as the major component ("N303" manufactured by Nagase & Company, Ltd.) to obtain an IZO pattern (lower electrode: anode, number of lines: 960).
As a first interlayer insulator, a negative-type resist ("V259PA" manufactured by Nippon Steel Chemical Co., Ltd.) was applied by spin coating, irradiated with ultraviolet rays through a photomask so that a specific pattern was formed, and developed using a TMAH (tetramethylammonium hydroxide) developer. The resulting resist was baked at 160°C to form an interlayer insulator which covered the edge of the IZO (IZO opening was 70x290 μm).
As a second interlayer insulator (partition wall), a negative-type resist ("ZPN1100" manufactured by Zeon Corporation) was applied by spin coating, irradiated with ultraviolet rays through a photomask so that a 20-μm line and 310-μm gap stripe pattern was formed, and baked. The negative-type resist was developed using a TMAH (tetramethylammonium hydroxide) developer to obtain a second interlayer insulator (partition wall) of organic films intersecting the IZO stripes at right angles.

The resulting substrate was subjected to ultrasonic cleaning in pure water and isopropyl alcohol, dried by air blowing, and subjected to UV cleaning.

The substrate was transferred to an organic deposition chamber (manufactured by ULVAC, Inc.) and secured on a substrate holder. Indivisual molybdenum heating boats were charged in advance with 4,4',4"-tris[N-(3-methylphenyl)-N-phenylamino]triphenylamine (MTDATA) and 4,4'-bis[N-(1-naphthyl)-N-phenylamino]biphenyl (NPD) as a hole injecting material, 4,4'-bis(2,2-diphenylvinyl)biphenyl (DPVBi) as an emitting material, and tris(8-quinolinol)aluminum (Alq) as an electron injecting material. As a cathode, an AlLi alloy (Li concentration: 10 atm%) was provided on a tungsten filament.

After reducing the pressure inside the vacuum chamber to $5\times10^{-7}$ torr, the layers from the hole injecting layer to the cathode were stacked as described below without breaking the vacuum.

As the hole injecting layer, MTDATA was deposited to a thickness of 60 nm at a deposition rate of 0.1 to 0.3 nm/sec and NPD was deposited to a thickness of 20 nm at a deposition rate of 0.1 to 0.3 nm/sec. As the emitting layer, DPVBi was deposited to a thickness of 50 nm at a deposition rate of 0.1 to 0.3 nm/sec. As the electron injecting layer, Alq was deposited to a thickness of 20 nm at a deposition rate of 0.1 to 0.3 nm/sec. As the cathode, Al and Li were deposited to a thickness of 150 nm at a deposition rate of 0.5 to 1.0 nm/sec. The organic layer (from hole injecting layer to electron injecting layer) were deposited with a mask and the cathode was deposited with a mask so that the cathode could be connected with the IZO lead electrode formed in advance. The cathode had a pattern (number of lines: 240) automatically separated by the partition walls formed on the substrate in advance.

(2) Formation of insulating film and barrier film

An insulating film was formed on the cathode of the organic EL device to a thickness of 150 nm by RF magnetron sputtering using an SiO target and $N_2$ gas at a sputtering pressure of 0.2 Pa and a sputtering power of 0.2 kW, and a barrier film was then formed by DC magnetron sputtering using an IZO target. The barrier film was formed to a thickness of 500 nm at a sputtering pressure of 0.2 Pa and a sputtering power of 0.7 kW using a mixed gas of oxygen (10%) and Ar. A glass lid was placed on the substrate through a UV-curable adhesive so that the organic EL device was completely covered, and bonded to the substrate by applying ultraviolet rays. The atomic composition of the SiON film was Si/N/O=50/40/10, and the atomic composition of the IZO film was In/Zn/O=27/3/70 (high resistivity).

A full-color organic EL display (aperture ratio: 56%) was thus produced in which the anodes and the cathodes formed an XY matrix. A DC voltage of 7 V was applied between the anode and the cathode (anode: (+), cathode: (-)). As a result, light was emitted from the intersecting point (pixel) of the electrodes.

The organic EL display was subjected to a 85°C storage test for 500 hours, and the reduction rate of the emitting pixel area was measured using a microscope. The reduction rate was 2%. This indicates that an organic EL display exhibiting excellent durability was obtained. The number of dark spots (DS) after the reliability evaluation was 0.2.

Example 13

An organic EL display was produced in the same manner as in Example 12 except that the insulating film and the barrier film were formed to have compositions as given below. The reliability evaluation was conducted in the same manner as in Example 12. The results are shown in Table 1.

Insulating film: SiON (Si/N/O=50/40/10)
Barrier film: TiN (Ti/N=52/48)

Example 14

An organic EL display was produced in the same manner as in Example 12 except for using a supporting substrate with a barrier film as given below as the supporting substrate. The reliability evaluation was conducted in the same manner as in Example 12. The results are shown in Table 1.

A barrier film was formed on a polyethersulfone substrate (manufactured by Sumitomo Bakelite Co., Ltd.) (thickness: 300 $\mu$m) cut to a size of 102 mm $\times$ 133 mm by DC magnetron sputtering using an IZO target. The barrier film was formed to a thickness of 500 nm at a sputtering pressure of 0.2 Pa and a sputtering power of 0.7 kW using a mixed gas of oxygen (10%) and Ar. An insulating film was formed in the same device by RF magnetron sputtering using an $SiO_2$ target. The insulating film was formed to a thickness of 150 nm at a sputtering pressure of 0.2 Pa and a sputtering power of 0.2 kW. A supporting substrate with a barrier film was thus obtained. Barrier film: IZO (In/Zn/O=27/3/70) (high resistivity)
Insulating film: SiO (Si/O=35/65)

TABLE 1

| | Classification | Device configuration | Barrier film | Pixel reduction (%) | Number of dark spots (number) |
|---|---|---|---|---|---|
| Example 1 | EL sealing | Top-emission active type | IZO (In/Zn/O=36/5/59) | 2 | 0.2 |
| Example 2 | | | IZO (In/Zn/O=27/3/70) (high resistivity) | 3 | 0.3 |
| Example 3 | | | ITO (In/Sn/O=37/3/60) | 3 | 0.5 |
| Example 4 | | | IZWO (In/Zn/W/O=34.4/6.6/0.2/58.8) | 2 | 0.2 |
| Example 5 | | | TiN (Ti/N=52/48) | 2 | 0.3 |
| Example 6 | | | ZrC (Zr/C=60/40) | 2 | 0.3 |
| Example 7 | | | LaB (La/B=55/45) | 4 | 0.6 |
| Example 8 | | | ZnS (Zn/S=60/40) | 4 | 0.5 |
| Comparative Example 1 | | | SiO (Si/O=35/65) | 50 | Several tens |
| Example 9 | | | IZO (In/Zn/O=36/5/59)+ SiON (Si/N/O=50/40/10) | 1 | 0.1 |
| Example 10 | | | SiON (Si/N/O=50/40/10)+ IZO (In/Zn/O=36/5/59) | <1 | 0 |
| Example 11 | | | SiON (Si/N/O=50/40/10)+ IZO (In/Zn/O=36/5/59)+ SiON (Si/N/O=50/40/10) | <1 | 0 |
| Example 12 | | Bottom-emission passive type | SiON (Si/N/O=50/40/10)+ IZO (In/Zn/O=27/3/70) (high resistivity) | 2 | 0.2 |
| Example 13 | | | SiON (Si/N/O=50/40/10)+ TiN (Ti/N=52/48) | 3 | 0.3 |
| Example 14 | | | (EL device) SiON (Si/N/O=50/40/10)+ IZO (In/Zn/O=27/3/70) (high resistivity) (Supporting substrate) IZO (In/Zn/O=27/3/70) (high resistivity)+ SiO (Si/O=35/65) | 10 | 20 |

Example 15

In this example, an organic EL display (bottom-emission passive type) with a layer configuration illustrated in FIG. 3 was produced by sequentially forming the color conversion layer 6, the barrier film 3, and the organic EL device 2 on the supporting substrate 1.

(1) Formation of color conversion film

V259BK (manufactured by Nippon Steel Chemical Co., Ltd.) as the material for a black matrix (BM) was applied by spin coating to a supporting substrate (transparent substrate) (OA2 glass manufactured by Nippon Electric Glass Co., Ltd.) having dimensions of 102x133x1.1 mm. Ultraviolet rays were applied through a photomask so that a lattice-shaped pattern was formed. The material was then developed using a 2% sodium carbonate aqueous solution and baked at 200°C to obtain a black matrix (thickness: 1.5 $\mu$m) pattern.

V259B (manufactured by Nippon Steel Chemical Co., Ltd.) as the material for a blue color filter was applied by spin coating. Ultraviolet rays were then applied through a photomask aligned with the BM so that 320 rectangular stripe patterns (90-$\mu$m line and 240-$\mu$m gap) were obtained. The material was then developed using a 2% sodium carbonate aqueous solution and baked at 200°C to obtain a blue color filter (thickness: 1.5 $\mu$m) pattern.

V259G (manufactured by Nippon Steel Chemical Co., Ltd.) as the material for a green color filter was applied by spin coating. Ultraviolet rays were then applied through a photomask aligned with the BM so that 320 rectangular stripe patterns (90-$\mu$m line and 240-$\mu$m gap) were obtained. The material was then developed using a 2% sodium carbonate aqueous solution and baked at 200°C to obtain a green color filter (thickness: 1.5 $\mu$m) pattern adjacent to the blue color filter.

V259R (manufactured by Nippon Steel Chemical Co., Ltd.) as the material for a red color filter was applied by spin coating. Ultraviolet rays were then applied through a photomask aligned with the BM so that 320 rectangular stripe patterns (90-$\mu$m line and 240-$\mu$m gap) were obtained. The material was then developed using a 2% sodium carbonate aqueous solution and baked at 200°C to obtain a red color filter (thickness: 1.5 $\mu$m) pattern between the blue color filter and the green color filter.

As the material for a green fluorescent medium, ink was prepared by dissolving coumarin 6 in an acrylic negative-type photoresist ("V259PA" manufactured by Nippon Steel Chemical Co., Ltd., solid content: 50%) in an amount of 0.04 mol/kg (with respect to the solid content).
The ink was applied to the substrate by spin coating, and ultraviolet rays were applied to the ink on the green color filter. The ink was then developed using a 2% sodium carbonate aqueous solution and baked at 200°C to form a green conversion film pattern (thickness: 10 $\mu$m) on the green color filter.

As the material for a red fluorescent medium, ink was prepared by dissolving 0.53 g of coumarin 6, 1.5 g of basic violet 11, and 1.5 g of rhodamine 6G in 100 g of an acrylic negative-type photoresist ("V259PA" manufactured by Nippon Steel Chemical Co., Ltd., solid content: 50%).
The ink was applied to the substrate by spin coating, and ultraviolet rays were applied to the ink on the red color filter. The ink was then developed using a 2% sodium carbonate aqueous solution and baked at 180°C to form a red conversion film pattern (thickness: 10 $\mu$m) on the red color filter, thus obtaining a color conversion substrate.

An acrylic thermosetting resin ("V259PH" manufactured by Nippon Steel Chemical Co., Ltd.) was applied to the substrate by spin coating and then baked at 180°C to form a planarization film (thickness: 12 $\mu$m).

(2) Formation of insulating film and barrier film

A barrier film was formed on the planarization film by DC magnetron sputtering using an IZO target. The barrier film was formed to a thickness of 500 nm at a sputtering pressure of 0.2 Pa and a sputtering power of 0.7 kW. An IZO high-resistivity layer was continuously formed using a mixed gas with an oxygen concentration of 10%. An insulating film was formed in the same device by RF magnetron sputtering using an SiO$_2$ target. The insulating film was formed to a thickness of 150 nm at a sputtering pressure of 0.2 Pa and a sputtering power of 0.2 kW. A color conversion substrate was thus obtained. The atomic composition of the IZO film was In/Zn/O=36/5/59, the atomic composition of the IZO high-resistivity layer was In/Zn/O=27/3/70, and the atomic composition of the SiO film was Si/O=35/65.

(3) Fabrication of passive type organic EL device

An organic EL device was fabricated on the color conversion substrate in the same manner as in Example 12. The organic EL display was subjected to a 85°C storage test for 500 hours, and the reduction rate of the emitting pixel area was measured using a microscope. The reduction rate was 2%. This indicates that an organic EL display exhibiting excellent durability was obtained.
The number of dark spots (DS) after the reliability evaluation was 0.2.

Examples 16 to 18

An organic EL display was produced in the same manner as in Example 15 except that the barrier film and the insulating film were formed to have compositions as given below. The reliability evaluation was conducted in the same manner as in Example 15. The results are shown in Table 2.

Example 16: IZWO (In/Zn/W/O=34.4/6.6/0.2/58.8), SiON (Si/N/O=50/40/10)
Example 17: TiN (Ti/N=52/48), alumino-borosilicate glass
Example 18: LaB (La/B=55/45), SiON (Si/N/O=50/40/10)

Comparative Example 2

An organic EL display was produced in the same manner as in Example 15 except that the barrier film was not formed. The reliability evaluation was conducted in the same manner as in Example 15.
The reduction ratio of the emitting pixel area was 100%. The durability of the organic EL display was significantly lower than that of the example.

TABLE 2

| | Classification | Device configuration | Barrier film | Pixel reduction (%) | Number of dark spots (number) |
|---|---|---|---|---|---|
| Example 15 | Color conversion layer barrier | Bottom-emission passive type | IZO (In/Zn/O=36/5/59)+ IZO (In/Zn/O=27/3/70) (high resistivity)+ SiO (Si/O=35/65) | 2 | 0.2 |
| Example 16 | | | IZWO (In/Zn/W/O=34.4/6.6/0.2/58.8) + SiON (Si/N/O=50/40/10) | 4 | 0.5 |
| Example 17 | | | TiN (Ti/N=52/48)+ alumino-borosilicate glass | 5 | 0.6 |
| Example 18 | | | LaB (La/B=55/45)+ SiON (Si/N/O=50/40/10) | 5 | 0.6 |
| Comparative Example 2 | | | None | 100 | |

Example 19

In this example, an organic EL display (top-emission TFT active type) with a layer configuration illustrated in FIG. 4 or 5 was produced by sequentially forming a TFT (not shown), the organic EL device 2, and the barrier film 3 on the supporting substrate 1.
The TFT and the organic EL device were fabricated in the same manner as in (1) and (2) of Example 1.

(Formation of barrier film)

A barrier film was formed on the organic EL device by DC magnetron reactive sputtering using an Si target and a mixed gas of Ar, oxygen, and nitrogen. The barrier film was formed at a sputtering pressure of 0.2 Pa and a sputtering power of 1.0 kW while controlling the internal stress by changing the mixing ratio of the oxygen gas and the nitrogen gas. As the initial condition, the barrier film was formed to a thickness of 600 nm at a mixing ratio of oxygen gas/nitrogen gas=20%:5%. The barrier film was then formed to a thickness of 200 nm at a mixing ratio of oxygen gas/ nitrogen gas=5%:20%.
Elemental analysis was conducted in the depth direction by X-ray photoelectron spectroscopy (XPS). The atomic fractions of the 600-nm layer on the substrate side were Si:O:N=1:1.5:0.3, and the atomic fractions of the 200-nm layer outside the 600-nm layer were Si:O:N=1:0.2>0.7. The layer on the substrate side containing a larger amount of oxygen serves as a stress reducing layer.
After forming the barrier film as an EL sealing film, a glass lid was placed on the substrate through a UV-curable adhesive so that the organic EL device was completely covered, and bonded to the substrate by applying ultraviolet rays to the adhesive to prevent external physical contact.
An active organic EL display was produced in this manner. A DC voltage of 7 V was applied between the anode (ITO/Cr) and the cathode (ITO) (anode: (+), cathode: (-)). As a result, light was emitted from the intersecting point (pixel) of the electrodes.
The active organic EL display was subjected to measurements of the pixel reduction ratio and dark spots in the same manner as in Example 1. The internal stress of the barrier film was measured using the following method.
(Measuring method for internal stress of barrier film)
The internal stress of the barrier film was measured using the measuring method described with reference to FIG. 8. A measurement specimen was obtained by forming the barrier film on an Si substrate as an internal stress measurement substrate simultaneously when forming the barrier film on the color conversion substrate.

The internal stress was calculated by optically detecting the flexure δ of the specimen (i.e. warping of the Si substrate). Table 3 shows the composition, film-formation method, and film-formation conditions of the barrier film used in Example 19, Examples 20 to 28, and Comparative Examples 3 and 4 described later. The evaluation results are shown in Table 4.

TABLE 3

| | Barrier film | | Film-formation method | Condition |
|---|---|---|---|---|
| | Substrate side: stress reducing layer | Outer side : barrier layer | | |
| Example 19 | Si/O/N=1/1.5/0.3 600 nm | Si/O/N=1/0.2/0.7 200 nm | Reactive DC sputtering | Si target, change in mixed gas ($O_2$, $N_2$) |
| Example 20 | Si/O/N=1/1.5/0.3 600 nm | Si/N=1/0.8 200 nm | | ratio |
| Comparative Example 3 | Si/N=1/0.8 800 nm single layer | | | Si target, $N_2$ gas Si target, $N_2$ gas |
| Example 21 | Si/O=1/1.7 600 nm | Si/Al/B/O=0.7/0.2/0.1/1.9 200 nm | RF | $SiO_2$ target, Corning 1737 |
| Example 22 | | Si/Al/O/N=0.6/0.4/0.3/0.4 200 nm | sputtering | $SiO_2$ target, SiAlON |
| Example 23 | Si/O=1/1.5 800 nm | Si/N=1/0.7 200 nm | CVD | gas ($SiH_4$, $O_2$)→ ($SiH_4$,$N_2$) |
| Example 24 | Si/O/N=1/1.4/0.3 500 nm | Si/O/N=1/0.2/0.6 200 nm | | Change in mixed gas ($SiH_4$,$N_2$, $N_2O$) ratio |
| Example 25 | Si/O/N/C=1/1.5/0.3/0.8 800 nm | Si/O/N/C=1/0.1/ 0.6/0.1 200 nm | | $TEOS+NH_3$ change in mixing ratio |
| Example 26 | Diamond-like carbon 1000 nm | Si/N=1/0.7 200 nm | | |
| Example 27 | C/N=1/0.8 600 nm | Si/N=1/0.7 200 nm | | ($CH_4+N_2$)→ ($SiH_4$, $N_2$) |
| Comparative Example 4 | Si/N=1/0.8 800 nm single | layer | | ($SiH4$, $N_2$) |
| Example 28 | Si/O/N=1/1.4/0.3 300 nm | Si/O/N=1/0.2/0.6 100 nm | | Change $N_2$, $N_2O$) ratio |
| In Table 3, the ratio of each atom is the atomic ratio when Si or C is 1. TEOS: tetraethoxysilane $Si(OC_2H_5)_4$ | | | | |

TABLE 4

| | Internal stress of barrier film | Pixel reduction ratio | Number of dark spots |
|---|---|---|---|
| Example 19 | 20 MPa | 1% | 0.2 |
| Example 20 | 30 MPa | 1% or less | 0 |
| Comparative Example 3 | 300 MPa | 60% | Several tens or more |

(continued)

|  | Internal stress of barrier film | Pixel reduction ratio | Number of dark spots |
|---|---|---|---|
| Example 21 | 40 MPa | 2% | 0.2 |
| Example 22 | 30 MPa | 2% | 0.2 |
| Example 23 | 30 MPa | 1% or less | 0 |
| Example 24 | 40 MPa | 1% or less | 0 |
| Example 25 | 20 MPa | 1% | 0.2 |
| Example 26 | 50 MPa | 4% | 0.5 |
| Example 27 | 50 MPa | 2% | 0.3 |
| Comparative Example 4 | 400 MPa | 80% | Several tens |
| Example 28 | 30 MPa | 10% | Twenty |

Example 20

An organic EL display was produced in the same manner as in Example 19 except for forming the barrier layer to a thickness of 200 nm at a mixing ratio of nitrogen gas/oxygen gas=20%/0%. The organic EL display was evaluated in the same manner as in Example 19. As shown in Table 4, excellent evaluation results were obtained.

Comparative Example 3

An organic EL display was produced in the same manner as in Example 19 except for forming the barrier film to a thickness of 800 nm using a mixed gas containing, 5% of oxygen gas, and 20% of nitrogen gas in base Ar gas. The organic EL display was evaluated in the same manner as in Example 19.
The reduction ratio of the emitting pixel area was 60%, which was inferior to that of the film formed in Example 19. As a result of observation using an electron microscope, it was confirmed that minute cracks partially occurred.
The internal stress was measured using an Si substrate film sample formed simultaneously when forming the barrier film. The internal stress was 300 MPa.

Example 21

An organic EL display was produced in the same manner as in Example 19 except for forming the barrier film by RF sputtering given below. The organic EL display was evaluated in the same manner as in Example 19.

(Formation of barrier film)

A film was formed on the organic EL device to a thickness of 600 nm by RF magnetron sputtering using an $SiO_2$ target and introducing Ar gas at a sputtering pressure of 0.2 Pa and a sputtering power of 0.5 kW. Another film was formed in the same device to a thickness of 200 nm using Corning 1737 as a target at a sputtering pressure of 0.2 Pa and a sputtering power of 0.5 kW.
Elemental analysis was conducted in the depth direction by XPS. The atomic fractions of the 600-nm layer on the substrate side were Si:0=1:1.7, and the atomic fractions of the 200-nm layer outside the 600-nm layer were Si:Al:B:O=0.7:0.2:0.1:1.9. The layer containing one metal element serves as a stress reducing layer.
As shown in Table 4, excellent evaluation results were obtained.

Example 22

An organic EL display was produced in the same manner as in Example 21 except for forming the barrier film by RF sputtering using an SiAlON target. The organic EL display was evaluated in the same manner as in Example 21. As shown in Table 4, excellent evaluation results were obtained.

Example 23

An organic EL display was produced in the same manner as in Example 19 except for forming the stress reducing layer using a method given below. The organic EL display was evaluated in the same manner as in Example 19. (Formation of barrier film)

The barrier film was formed on the organic EL device by plasma CVD. The barrier film was formed at a deposition power of 100 W using a mixed gas of $SiH_4$ gas, nitrogen gas, and $N_2O$ gas while controlling the internal stress by changing the mixing ratio of the oxygen gas and the $N_2O$ gas. As the initial condition, the barrier film was formed to a thickness of 800 nm at a mixing ratio of $SiH_4$ gas/oxygen gas=30%:70%. The barrier film was then formed to a thickness of 200 nm at a mixing ratio of $SiH_4$ gas/nitrogen gas=15%:85%.

Elemental analysis was conducted in the depth direction by XPS. The atomic fractions of the 800-nm layer on the substrate side were Si:O=1 : 1.5, and the atomic fractions of the 200-nm layer outside the 800-nm layer were Si: N=1:0.7. The layer on the substrate side containing a larger amount of oxygen serves as a stress reducing layer. As shown in Table 4, excellent evaluation results were obtained.

Examples 24 to 27

The barrier film was formed in the same manner as in Example 23 except for changing the raw material gas and the thickness of the stress reducing layer as shown in Table 5.

As shown in Table 4, excellent evaluation results were obtained.

TABLE 5

| | Deposition gas | |
|---|---|---|
| | Substrate side (stress reducing layer) | Outer side (barrier layer) |
| Example 24 | $SiH_4$: 15%<br>$N_2$: 30%<br>$N_2O$: 55% | $SiH_4$: 15%<br>$N_2$: 80%<br>$N_2O$: 5% |
| Example 25 | TEOS | TEOS: 80%<br>$NH_3$: 20% |
| Example 26 | $CH_4$ | $SiH_4$: 15%<br>N2: 85% |
| Example 27 | $CH_4$: 50%,<br>$N_2$: 50% | SiH: 15%<br>$N_2$: 85% |
| TEOS:tetraethoxysilane $Si(OC_2H_5)_4$ | | |

Comparative Example 4

An organic EL display was produced in the same manner as in Example 23 except for forming the barrier film to a thickness of 800 nm at a mixing ratio of $SiH_4$ gas/nitrogen gas=15%:85%. The organic EL display was evaluated in the same manner as in Example 23.

The reduction ratio of the emitting pixel area was 80%, which was inferior to that of the film formed in Example 23. As a result of observation using an electron microscope, it was confirmed that minute cracks partially occurred.

The internal stress was measured using an Si substrate film sample formed simultaneously when forming the barrier film. The internal stress was 400 MPa.

Example 28

An organic EL display was produced in the same manner as in Example 24 except for using polyethersulfone (manufactured by Sumitomo Bakelite Co., Ltd.) (plastic film substrate) as the supporting substrate and changing the thickness of the barrier film. The organic EL display was evaluated in the same manner as in Example 24.

As shown in Table 4, excellent evaluation results were obtained.

Example 29

(1) Formation of color conversion layer

A color conversion layer was formed in the same manner as in Example 15.

(2) Formation of barrier film

A barrier film was formed on the planarization film by DC magnetron reactive sputtering using an Si target and a mixed gas of Ar, oxygen, and nitrogen. The barrier film was formed at a sputtering pressure of 0.2 Pa and a sputtering power of 1.0 kW while controlling the internal stress by changing the mixing ratio of the oxygen gas and the nitrogen gas. As the initial condition, the barrier film was formed to a thickness of 600 nm at a mixing ratio of oxygen gas/nitrogen gas=20%:5%. The barrier film was then formed to a thickness of 200 nm at a mixing ratio of oxygen gas/nitrogen gas=5%: 20%. A color conversion substrate was thus obtained.
Elemental analysis was conducted in the depth direction by X-ray photoelectron spectroscopy (XPS). The atomic fractions of the 500-nm layer on the substrate side were Si:O:N=1:1.5:0.3, and the atomic fractions of the 150-nm layer outside the 500-nm layer were Si:O:N=1:0.2:0.7. The layer on the substrate side containing a larger amount of oxygen serves as a stress reducing layer.

(3) Fabrication of passive type organic EL display

An organic EL device was fabricated on the color conversion substrate obtained in (2) using the same method as in (1) of Example 12. The resulting organic EL display was subjected to measurements of the pixel reduction ratio and dark spots in the same manner as in Example 1.

(4) Measurement of water vapor transmission rate

The water vapor transmission rate measured in the same manner as in Example 19 was 0.001 $g/m^2 \cdot 24hr$ (measurement lower limit) or less. It was confirmed that a sufficient organic EL display performance was obtained. Table 6 shows the composition, film-formation method, and film-formation conditions of the barrier film used in Example 29 and Examples 30 to 32 described later. The evaluation results are shown in Table 7.
TABLE 6

| | Barrier film | | Film-formation method | Condition |
| --- | --- | --- | --- | --- |
| | Substrate side: stress reducing layer | Outer side: barrier layer | | |
| Example 29 | Si/O/N=1/1.5/0.3 600 nm | Si/O/N=1/0.2/0.7 200 nm | Reactive DC sputtering | si target, change in mixed gas ($O_2$, $N_2$) ratio Si target, change in mixed gas ($O_2$, $N_2$) ratio |
| Example 30 | Si/O=1/1.7 600 nm | Si/Al/B/O= 0.7/0.2/0.1/1.9 200 nm | RF sputtering | $SiO_2$ target, Corning 1737 |
| Example 31 | Si/O=1/1.5 1000 nm | Si/N=1/0.7 200 nm | CVD | Gas ($SiH_4$,$O_2$)→($SiH_4$, $N_2$) TEOS+$NH_3$, change in mixing ratio |
| Example 32 | Si/O/N/C= 1/1.5/0.3/0.8 800 nm | Si/O/N/C= 1/0.1/0.6/0.1 200 nm | | |
| In Table 6, the ratio of each atom is the atomic ratio when Si or C is 1. TEOS:tetraethoxysilane Si($OC_2H_5$)$_4$ | | | | |

TABLE 7

| | Pixel reduction ratio | Number of dark spots |
| --- | --- | --- |
| Example 29 | 2% | 0.4 |
| Example 30 | 3% | 0.5 |
| Example 31 | 1% | 0.2 |
| Example 32 | 2% | 0.4 |

In the organic EL display produced in Example 29, cracks and delamination of the barrier film did not occur in the anode formation and patterning steps for fabricating the organic EL device.

Example 30

An organic EL display was produced in the same manner as in Example 29 except for forming the barrier film on the planarization film under the same conditions as in Example 21. The organic EL display was evaluated in the same manner as in Example 29.
As shown in Table 7, excellent evaluation results were obtained.

Example 31

An organic EL display was produced in the same manner as in Example 29 except for forming the barrier film on the planarization film under the same conditions as in Example 23 and changing the thickness of the stress reducing layer to 1000 nm. The organic EL display was evaluated in the same manner as in Example 29.
As shown in Table 7, excellent evaluation results were obtained.

Example 32

An organic EL display was produced in the same manner as in Example 29 except for forming the barrier film on the planarization film under the same conditions as in Example 25. The organic EL display was evaluated in the same manner as in Example 29.
As shown in Table 7, excellent evaluation results were obtained.
In the organic EL displays produced in Examples 30 to 32, cracks and delamination of the barrier film did not occur in the anode formation and patterning steps for fabricating the organic EL device.

INDUSTRIAL APPLICABILITY

The organic EL display according to the invention can be used as consumer and industrial displays such as displays for portable telephones, PDAs, car navigation systems, monitors, TVs, and the like.

**Claims**

1. An organic electroluminescent display comprising:

   an organic electroluminescent device; and
   a barrier film which seals the organic electroluminescent device and comprises a conductive film.

2. An organic electroluminescent display comprising:

   an organic electroluminescent device;
   a color conversion layer which adjusts and/or converts color of light from the organic electroluminescent device; and
   a barrier film which seals the color conversion layer and comprises a conductive film.

3. An organic electroluminescent display comprising:

   a supporting substrate; an organic electroluminescent device formed on the supporting substrate; and
   a barrier film which is formed on a side of the organic electroluminescent device opposite to the supporting substrate and/or between the organic electroluminescent device and the supporting substrate and comprises a conductive film.

4. An organic electroluminescent display comprising in this order:

   a supporting substrate;
   a color conversion layer which adjusts and/or converts color of light from an organic electroluminescent device;
   a barrier film comprising a conductive film; and

an organic electroluminescent device.

5. The organic electroluminescent display according to any one of claims 1 to 4, wherein the conductive film of the barrier film is separated from an electrode of the organic electroluminescent device on the barrier film side.

6. The organic electroluminescent display according to claim 5, comprising an insulating film provided between the conductive film and the electrode of the organic electroluminescent device on the barrier film side.

7. The organic electroluminescent display according to claim 6, wherein the insulating film is formed of at least one material selected from an oxide, nitride, oxynitride, and chalcogenide.

8. The organic electroluminescent display according to any one of claims 1 to 4, wherein the conductive film is formed of a material differing from that of an electrode of the organic electroluminescent device on the barrier film side.

9. The organic electroluminescent display according to any one of claims 1 to 4, wherein the conductive film is formed of a noncrystalline material.

10. The organic electroluminescent display according to any one of claims 1 to 4, wherein the conductive film is formed of at least one material selected from an oxide, nitride, oxynitride, carbide, boride, and chalcogenide.

11. The organic electroluminescent display according to any one of claims 1 to 4, wherein the conductive film is formed of a compound containing at least one element selected from In, Zn, Sn, W, Zr, and Ta.

12. The organic electroluminescent display according to any one of claims 1 to 4, wherein the conductive film has a specific resistivity of $10^8$ $\Omega \cdot$cm or less.

13. The organic electroluminescent display according to any one of claims 1 to 4, wherein the supporting substrate is a plastic substrate.

14. The organic electroluminescent display according to any one of claims 1 to 4, wherein the barrier film is formed by vapor deposition.

15. The organic electroluminescent display according to claim 14, wherein the vapor deposition is sputtering.

16. The organic electroluminescent display according to any one of claims 1 to 4, wherein the organic electroluminescent display is an active drive type display, and the conductive film is electrically connected with an electrode of the organic electroluminescent device on the barrier film side.

17. An organic electroluminescent display comprising:

    an organic electroluminescent device; and
    a barrier film which seals the organic electroluminescent device and comprises a stress reducing layer.

18. An organic electroluminescent display comprising:

    an organic electroluminescent device;
    a color conversion layer which adjusts and/or converts color of light from the organic electroluminescent device; and
    a barrier film which seals the color conversion layer and comprises a stress reducing layer.

19. An organic electroluminescent display comprising:

    a supporting substrate;
    an organic electroluminescent device formed on the supporting substrate; and
    a barrier film which is formed on a side of the organic electroluminescent device opposite to the supporting substrate and/or between the organic electroluminescent device and the supporting substrate and comprises a stress reducing layer.

20. An organic electroluminescent display comprising in this order:

a supporting substrate;
a color conversion layer which adjusts and/or converts color of light from an organic electroluminescent device;
a barrier film comprising a stress reducing layer; and
an organic electroluminescent device.

21. The organic electroluminescent display according to any one of claims 17 to 20, wherein the barrier film comprising a stress reducing layer is formed by vapor deposition.

22. The organic electroluminescent display according to claim 21, wherein the vapor deposition is sputtering or chemical vapor deposition (CVD).

23. The organic electroluminescent display according to any one of claims 17 to 20, wherein the barrier film comprising a stress reducing layer contains an inorganic metal compound.

24. The organic electroluminescent display according to claim 23, wherein the inorganic metal compound is an oxide, nitride, carbide, oxynitride, oxycarbide, or carbide nitride.

25. The organic electroluminescent display according to claim 23, wherein the inorganic metal compound is a compound of the following formula (1),

$$M^1uM^2vNxOyCz \qquad (1)$$

wherein $M^1$ and $M^2$ represent different metal elements; u and v satisfy $0 \leq u$, $v \leq 1$; and x, y, and z satisfy $0 \leq x$, y, z when u+v=1; provided that x>0.6 and y+z<0.2 are satisfied for the barrier layer, and x<0.2 and y+z>0.6 are satisfied for the stress reducing layer.

26. The organic electroluminescent device according to claim 23, wherein the inorganic metal compound is a compound of the following formula (2),

$$M^1M^2 ... M^nO \qquad (2)$$

wherein $M^1$, $M^2$, ..., and $M^n$ represent different metal elements, and n represents an integer of 2 or more for the barrier layer and represents 1 for the stress reducing layer.

27. The organic electroluminescent display according to any one of claims 24 to 26, wherein a metal of the inorganic metal compound includes at least one element selected from Si, Al, and Zn.

28. The organic electroluminescent display according to any one of claims 17 to 20, wherein the barrier film comprising a stress reducing layer is an amorphous film containing carbon.

29. The organic electroluminescent display according to any one of claims 17 to 20, wherein the barrier film comprising a stress reducing layer has an absolute value of internal stress of 200 MPa or less.

30. The organic electroluminescent display according to any one of claims 17 to 20, wherein the supporting substrate is a plastic substrate.

FIG. 1

(a)

(b)

FIG. 2

FIG. 3

FIG. 4

(a)

(b)

FIG. 5

Fig. 6

FIG. 7

FIG. 8

(a)

(b)

(c)

## FIG. 9

(a) — Deposit of α-Si on Substrate

(b) — Laser Annealing Crystallization KrF(248nm)

(c) — Patterning of Polysilicon Layer

(d) — Deposit of Gate Insulating Layer

(e) — Deposit of Al or Polysilicon Layer

(f) — First Anodization

(g) — Patterning of Gate Al — Photo Resist

(h) — Second Anodization

(i) — Ion Doping — Gate Inslating Layer — Ion Doping

FIG. 10

FIG. 11

<div align="center">

### INTERNATIONAL SEARCH REPORT

</div>

| | International application No. |
|---|---|
| | PCT/JP2005/005236 |

A. CLASSIFICATION OF SUBJECT MATTER
Int.Cl⁷ H05B33/04, 33/02, 33/12, 33/14

According to International Patent Classification (IPC) or to both national classification and IPC

B. FIELDS SEARCHED

Minimum documentation searched (classification system followed by classification symbols)
Int.Cl⁷ H05B33/04, 33/02, 33/12, 33/14

Documentation searched other than minimum documentation to the extent that such documents are included in the fields searched
Jitsuyo Shinan Koho          1922-1996    Jitsuyo Shinan Toroku Koho    1996-2005
Kokai Jitsuyo Shinan Koho    1971-2005    Toroku Jitsuyo Shinan Koho    1994-2005

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br><br><br>Y | JP 2003-17244 A (Sony Corp.),<br>17 January, 2003 (17.01.03),<br>Par. Nos. [0010] to [0052]; Figs. 1, 2<br>(Family: none) | 1,5,6,8,<br>12-15,17,21,<br>22,30<br>7,9-11,16,<br>26-28 |
| X | JP 2004-101862 A (Pioneer Electronic Corp.),<br>02 April, 2004 (02.04.04),<br>Par. Nos. [0006] to [0026]; Figs. 2 to 5<br>(Family: none) | 1-5 |
| X | JP 2000-111721 A (Fuji Denki Kabushiki Kaisha),<br>21 April, 2000 (21.04.00),<br>Par. Nos. [0025] to [0031], [0037], [0065] to<br>[0098]; Figs. 1 to 4<br>& GB 002344346 A | 17-20 |

| ☒ Further documents are listed in the continuation of Box C. | ☐ See patent family annex. |
|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>13 July, 2005 (13.07.05) | Date of mailing of the international search report<br>26 July, 2005 (26.07.05) |
|---|---|
| Name and mailing address of the ISA/<br>Japanese Patent Office | Authorized officer |
| Facsimile No. | Telephone No. |

Form PCT/ISA/210 (second sheet) (January 2004)

**INTERNATIONAL SEARCH REPORT**

| International application No. |
|---|
| PCT/JP2005/005236 |

C (Continuation).   DOCUMENTS CONSIDERED TO BE RELEVANT

| Category* | Citation of document, with indication, where appropriate, of the relevant passages | Relevant to claim No. |
|---|---|---|
| Y | JP 2003-282237 A  (Toyota Central Research And Development Laboratories, Inc.), 03 October, 2003 (03.10.03), Par. Nos. [0008] to [0018]; Figs. 3 to 5 (Family: none) | 7,28 |
| X Y | JP 2003-297547 A  (Idemitsu Kosan Co., Ltd.), 17 October, 2003 (17.10.03), Par. Nos. [0010] to [0011], [0058], [0075] to [0089]; Figs. 1 to 6 (Family: none) | 17,18,23-25 29 |
| Y | JP 2003-187975 A  (Idemitsu Kosan Co., Ltd.), 04 July, 2003 (04.07.03), Par. Nos. [0014] to [0050]; Figs. 1 to 3 (Family: none) | 9-11,26-27 |
| Y | JP 11-339969 A  (TDK Corp.), 10 December, 1999 (10.12.99), Claims; Par. Nos. [0006] to [0018] (Family: none) | 29 |

Form PCT/ISA/210 (continuation of second sheet) (January 2004)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2002025765 A
- JP 2003017244 A
- JP 2002117973 A
- JP 10247587 A
- JP 2000068560 A
- JP 2004031242 A
- JP 2000182780 A
- JP 2003257657 A
- JP 2001284042 A
- JP 2003282237 A
- WO 02017689 A
- WO 03043382 A
- WO 03069957 A
- JP 3002798 W
- JP 2002301852 A